# EUROPEAN PATENT SPECIFICATION

(11) **EP 4 456 072 B1**
(45) Date of publication and mention of the grant of the patent: **07.10.2026**
(21) Application number: 24172130.7
(22) Date of filing: 24.04.2024
(51) Int. Cl.: G11C 29/02, G06F 13/16

(54) **MEMORY ACCESS LATENCY ESTIMATION METHOD AND MEMORY ACCESS LATENCY ESTIMATION SYSTEM FOR ESTIMATING AN ACCESS LATENCY OF A MEMORY ACCORDING TO A PLURALITY OF COEFFICIENTS AND A PLURALITY OF INDEXES**
SPEICHERZUGRIFFLATENZSCHÄTZVERFAHREN UND SPEICHERZUGRIFFLATENZSCHÄTZSYSTEM ZUR SCHÄTZUNG EINER SPEICHERZUGRIFFLATENZ NACH MEHREREN KOEFFIZIENTEN UND INDIZES
PROCÉDÉ ET SYSTÈME D'ESTIMATION DE LATENCE D'ACCÈS MÉMOIRE POUR ESTIMER UNE LATENCE D'ACCÈS D'UNE MÉMOIRE

(30) Priority: 25.04.2023 US 202363498029 P; 23.04.2024 US 202418642859
(43) Date of publication of application: 30.10.2024
(73) Proprietor: MediaTek Inc., Hsin-Chu 300 (TW)
(72) Inventor: CHANG, Chih-Chieh, 30078 Hsinchu City (TW); SUN, You-Hong, 30078 Hsinchu City (TW); LIN, Wen-Hsun, 30078 Hsinchu City (TW); CHANG, Chia-Ching, 30078 Hsinchu City (TW)
(74) Representative: Hoefer & Partner Patentanwälte mbB

(56) References cited:
- US-A1- 2020 301 606
- SILVA KARILA PALMA ET AL: "Value analysis for the determination of memory instruction latency in a WCET tool", 2015 IEEE 13TH INTERNATIONAL CONFERENCE ON INDUSTRIAL INFORMATICS (INDIN), IEEE, 22 July 2015 (2015-07-22), pages 252 - 257, XP033218791, DOI: 10.1109/INDIN.2015.7281743
- SHEN HUANXING HUANXING SHEN@INTEL COM ET AL: "Runtime Estimation of Application Memory Latency for Performance Analysis and Optimization", 2020 2ND SYMPOSIUM ON SIGNAL PROCESSING SYSTEMS, ACMPUB27, NEW YORK, NY, USA, 28 September 2020 (2020-09-28), pages 1 - 9, XP058583695, ISBN: 978-1-4503-8858-0, DOI: 10.1145/3422575.3422773

## Description

### Cross Reference to Related Applications

This application claims the benefit of U.S. Provisional Application No. 63/498,029, filed on April 25th, 2023.

### Background

When accessing a memory (e.g. DRAM), if the access latency of the memory is longer, the waiting time of a processor will be longer, increasing the power consumption of the processor. If the accessing frequency of memory is increased, the access latency may be reduced, but it will increase the power consumption of the memory. Since the access latency of the memory is related to the power consumption, it is helpful for managing power consumption to estimate the access latency correctly. However, it is a challenge to estimate and control the access latency of the memory, and a solution for controlling the access latency is still in need in the field.

Document US 2020/0301606 A1 discloses a solid state drive system that receives read commands, write commands, and/or file system updates. The solid state drive system then determines the latency estimate for performing each of those commands asynchronously. The solid state drive system may utilize internal processes to determine the latency estimate. The latency estimate may include random access latency, block erase time, outstanding workload latency, garbage collection time, metadata write time, etc. The latency estimate is then returned to the host device. The host device may utilize the latency estimate to workload balance solid state drive systems.

### Summary

A method and a memory access latency estimation system according to the invention are defined in the independent claims. The dependent claims define preferred embodiments thereof. An embodiment of the invention provides the memory access latency estimation method. The memory access latency estimation method includes measuring a first access latency of a first access operation of a first memory; measuring a plurality of first indexes of the first memory corresponding to the first access operation, using a plurality of first coefficients and the plurality of first indexes to perform a first weighted calculation to generate a first estimated latency, adjusting the plurality of first coefficients to generate a plurality of updated first coefficients, using the plurality of updated first coefficients and the plurality of first indexes to perform the first weighted calculation to adjust the first estimated latency for the first estimated latency to approximate the first access latency, and using the plurality of updated first coefficients and a plurality of second indexes of the first memory to perform a second weighted calculation to generate a second estimated latency for a second access operation. Number and types of the plurality of first indexes are the same as number and types of the plurality of second indexes, the plurality of second indexes are corresponding to the second access operation, and the first access operation precedes the second access operation.

Another embodiment of the invention provides the memory access latency estimation system that includes a first monitor, a plurality of second monitors and a processor. The first monitor is used to measure a first access latency of a first access operation of a first memory. The plurality of second monitors are used to measuring a plurality of first indexes of the first memory corresponding to the first access operation. The processor is used to use a plurality of first coefficients and the plurality of first indexes to perform a first weighted calculation to generate a first estimated latency, adjust the plurality of first coefficients to generate a plurality of updated first coefficients in order to use the plurality of updated first coefficients and the plurality of first indexes to perform the first weighted calculation to adjust the first estimated latency for the first estimated latency to approximate the first access latency, and use the plurality of updated first coefficients and a plurality of second indexes of the first memory to perform a second weighted calculation to generate a second estimated latency for a second access operation. Number and types of the plurality of first indexes are the same as number and types of the plurality of second indexes, the plurality of second indexes are corresponding to the second access operation, and the first access operation precedes the second access operation.

An embodiment useful to understand the invention provides a memory access latency estimation method, including measuring a plurality of first indexes of a first memory, measuring a plurality of second indexes of a second memory, obtaining a relationship between the plurality of first indexes of the first memory and the plurality of second indexes of the second memory, and generating a plurality of second coefficients for the second memory according to the relationship and a plurality of first coefficients of the first memory. The plurality of second coefficients are used to estimate an access latency of the second memory, and number and the types of the plurality of first indexes are the same as number and types of the plurality of second indexes.

These and other objectives of the present invention will no doubt become obvious to those of ordinary skill in the art after reading the following detailed description of the preferred embodiment that is illustrated in the various figures and drawings.

### Brief Description of the Drawings

FIG.1 illustrates a memory access latency estimation system for controlling a first memory according to an embodiment.
FIG.2 illustrates a memory access latency estimation system for controlling the first memory and a second memory according to another embodiment.
FIG.3 illustrates a flowchart of a memory access latency estimation method for the memory access latency estimation system in FIG.1 according to an embodiment.
FIG.4 illustrates a flowchart of a method for the memory access latency estimation system in FIG.2 according to another embodiment.
FIG.5 illustrates a memory access latency estimation system for controlling the first memory and a second memory according to another embodiment.
FIG.6 illustrates a flowchart of a memory access latency estimation method for the memory access latency estimation system in FIG.5.

### Detailed Description

In the text, a bandwidth may be an amount of data transmitted per unit time. The larger the bandwidth, the more data may be transmitted per unit time. In the text, an asterisk (i.e. *) may be the multiplication sign. In the text, a neural network model or a machine learning model may include hardware and software integrated in a model and used for machine learning. For example, a neural network model may include a convolutional neural network (CNN), a recurrent neural network (RNN), a deep neural network (DNN) and/or a proper neural network model.

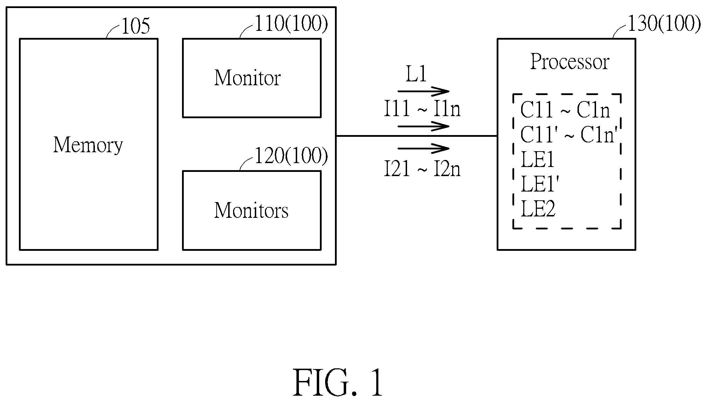

FIG.1 illustrates a memory access latency estimation system 100 for controlling a first memory 105 according to an embodiment. The memory access latency estimation system 100 may include a monitor 110, a plurality of monitors 120 and a processor 130.

The monitor 110 may measure an access latency L1 of an access operation of the first memory 105. The monitors 120 may measure a plurality of indexes I11 to I1n of the first memory 105 corresponding to the access operation. Here, the access latency L1 is an actual latency obtained by measurement instead of by estimation.

The processor 130 may use a plurality of coefficients C11 to C1n and the indexes I11 to I1n to perform a weighted calculation to generate an estimated latency LE1. The weighted calculation may be expressed as the following equation eq-1. $LE 1 = C 11 * I 11 + C 12 * I 12 + … + C 1 n * I 1 n$ eq-1.

The processor 130 may adjust the coefficients C1 1 to C1n to generate a plurality of updated coefficients C11' to C1n' in order to use the updated coefficients C11' to C1n' and the indexes I11 to I1n to perform the weighted calculation to adjust the estimated latency LE1 to generate an updated estimated latency LE1' for the updated estimated latency LE1' to approximate the access latency L1. The weighted calculation with the updated coefficients C11' to C1n' may be expressed as the following equation eq-2. $LE 1 ′ = C 11 ′ * I 11 + C 12 ′ * I 12 + … + C 1 n ′ * I 1 n$ eq-2.

The updated coefficients C11' to C1n' may be further adjusted by a machine learning model (e.g. neural network model) of the processor 130 to further adjust the updated estimated latency LE1' for the updated estimated latency LE1' to be closer to the access latency L1. The updated coefficients C11' to C1n' may be adjusted and improved recursively to adjust the updated estimated latency LE1' to be closer to the actual access latency L1.

After the updated coefficients C11' to C1n' are generated, the updated coefficients C11' to C1n' may be used to generate an estimated latency for the first memory 105.

The processor 130 may use the updated coefficients C11' to C1n' and a plurality of indexes I21 to I2n of the first memory 105 to perform a weighted calculation to generate an estimated latency LE2 for a later access operation. The weighted calculation may be expressed as the following equation eq-3. $LE 2 = C 11 ′ * I 21 + C 12 ′ * I 22 + … + C 1 n ′ * I 2 n$ eq-3.

Here, the estimated latency LE2 is an estimated latency instead of an actual latency obtained through measurement. The estimated latency LE2 corresponding to the access operation may be generated before an actual latency is measured. The estimated latency LE2 may be used by the processor 130 to manage and reduce the power consumption of the later access operation of the first memory 105.

After the later access operation is completed, an actual latency of the new access operation may be measured, for example, by the monitor 110. The updated coefficients C11' to C1n' may be further adjusted and improved according to the estimated latency LE2 and the actual latency of the later access operation to adjust the result of the equations eq-3 to be closer to the actual latency. Hence, subsequent estimations will be more accurate with the updated coefficients. In the process, the adjustment of the coefficients and the related calculations may be performed using the neural network model in the processor 130.

In the process, the number and the types of the indexes I11 to I1n may be the same as the number and the types of the indexes I21 to I2n. The access operation with the latency L1 may precede the later access operation. The updated coefficients (e.g. C11' to C1n') may be used to generate the estimated latency LE2 for the later access operation to improve power management and controls related to data accessing of the first memory 105. The types of the indexes I11 to I1n and the indexes I21 to I2n will be described below.

After the updated coefficients C11' to C1n' for the first memory 105 are obtained, an access latency of a second memory 205 may be estimated according to the result of optimizing the estimation of the access latency for the first memory 105.

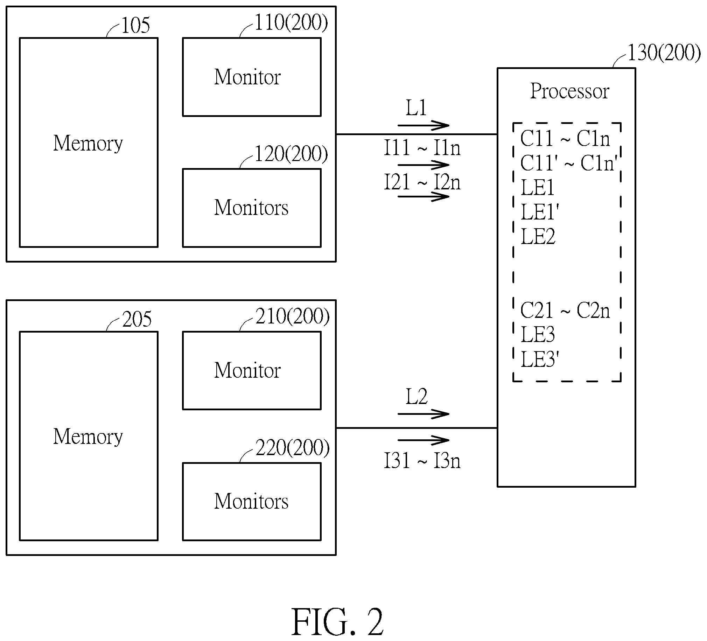

FIG.2 illustrates a memory access latency estimation system 200 for controlling the first memory 105 and a second memory 205 according to another embodiment. In FIG.2, the first memory 105, the monitor 110 and the monitors 120 may be similar to that in FIG. 1. Compared to the memory access latency estimation system 100, the memory access latency estimation system 200 may further include a monitor 210 and a plurality of monitors 220.

The monitor 210 may measure an access latency L2 of an access operation of the second memory 205. The monitors 220 may measure a plurality of indexes I31 to I3n of the second memory 205 corresponding to the access operation of the second memory 205.

The processor 130 may further use the foresaid updated coefficients C11' to C1n' (corresponding to the first memory 105) and the indexes I31 to I3n (corresponding to the second memory 205) to perform an weighted calculation to generate an estimated latency LE3 for the second memory 205, and weighted calculation may be expressed as the following equation eq-4. $LE 3 = C 11 ′ * I 31 + C 12 ′ * I 32 + … + C 1 n ′ * I 3 n$ eq-4.

The processor 130 may adjust the updated coefficients C11' to C1n' to generate a plurality of coefficients C21 to C2n. Then, the processor 130 may use the coefficients C21 to C2n and the indexes I31 to I3n to perform the weighted calculation (e.g. eq-4) to adjust the estimated latency LE3 to approximate the access latency L2, and the calculation may be expressed as the following equation eq-5. $LE 3 ′ = C 21 * I 31 + C 22 * I 32 + … + C 2 n * I 3 n$ eq-5.

In the equation eq-5, the estimated latency LE3' may be generated using the coefficients C21 to C2n, and the estimated latency LE3' may be closer to the access latency L2 (i.e. actual latency) than the estimated latency LE3.

After generating the coefficients C21 to C2n, the processor 130 may obtain and store a relationship between the updated coefficients C11' to C1n' and the coefficients C21 to C2n. The updated coefficients C11' to C1In' are corresponding to the first memory 105, and the coefficients C21 to C2n are corresponding to the second memory 205. The relationship may be expressed as a function f(), and the relationship between the updated coefficients C11' to C1n' and the coefficients C21 to C2n may be expressed as the following equation eq-6. $f \left(C11′, C12′, C13′, …, C1n′\right) = \left(C21, C22, …, C2n\right)$ eq-6.

After obtaining the relationship (i.e. the function f()) between the coefficients for the first memory 105 (e.g. C11' to C1n') and the coefficients for the second memory 205 (e.g. C21 to C2n), the processor 130 may estimate a group of coefficients corresponding to the second memory 205 according to a group of coefficients corresponding to the first memory 105 and the relationship f().

For example, if a first chip having the first memory 105 is modified and upgraded to design a second chip having the second memory 205, the coefficients for estimating the latency of the first memory 105 in the first chip may be converted to the coefficients for estimating the latency of the second memory 205 in the second chip. Optionally, the coefficients for estimating the latency of the second memory 205 in the second chip may be further adjusted to be more accurate. As a result, resources used for generating the coefficients for estimating the access latency of the second memory 205 are reduced.

The processor 130, the monitors 110, 120, 210 and 220 may be implemented using hardware such as circuits. Appropriate software and/or firmware may be installed in the processor 130, and the monitors 110, 120, 210 and 220 to perform related operations. The first memory 105 and the second memory 205 may be dynamic random-access memories, such as DDR (double data rate) memories. The processor 130 may include a central processing unit (CPU), a graphic processing unit (GPU), a tensor processing unit (TPU), a neural network processing unit (NPU), an application specific integrated circuit (ASIC), a deep learning processing unit (DPU), a vector processing unit (VPU), a microprocessor, a micro controller unit (MCU) and/or an appropriate processing unit.

Regarding the indexes I11 to I1n, the indexes I21 to I2n, and the indexes I31 to I3n, at least one of the indexes may include a bandwidth of a corresponding memory (e.g. the first memory 105 or the second memory 205).

Regarding the indexes I11 to I1n, the indexes I21 to I2n, and the indexes I31 to I3n, at least one of the indexes may include a reciprocal of an operation frequency of a corresponding memory (e.g. the first memory 105 or the second memory 205).

Regarding the indexes I11 to I1n, the indexes I21 to I2n, and the indexes I31 to I3n, at least one of the indexes may include a reciprocal of an operation frequency of an interface for a corresponding memory (e.g. the first memory 105 or the second memory 205). For example, the interface may include an external memory interface (EMI).

Regarding the indexes I11 to I1n, the indexes I21 to I2n, and the indexes I31 to I3n, at least one of the indexes may include a reciprocal of a parameter corresponding to a transaction priority of a corresponding memory (e.g. the first memory 105 or the second memory 205). A transaction priority of a memory may refer to the priority levels assigned to memory operations in a system, and it may determine the order in which different tasks or processes access memory resources, ensuring that more critical or time-sensitive operations take precedence.

Regarding the indexes I11 to I1n, the indexes I21 to I2n, and the indexes I31 to I3n, at least one of the indexes may include a parameter corresponding to variety of access patterns of a corresponding memory (e.g. the first memory 105 or the second memory 205). In computer engineering, a memory access pattern may be the pattern with which a system or program reads and writes a memory.

Regarding the indexes I11 to I1n, the indexes I21 to I2n, and the indexes I31 to I3n, at least one of the indexes may include a squared value of the bandwidth of a corresponding memory (e.g. the first memory 105 or the second memory 205).

Regarding the indexes I11 to I1n, the indexes I21 to I2n, and the indexes I31 to I3n, at least one of the indexes may include a ratio of a frequency of a corresponding memory (e.g. the first memory 105 or the second memory 205) to a frequency of an interface. For example, the frequency of the memory may be a frequency of a DDR (double data rate) memory, and the frequency of the interface may be a frequency of an external memory interface (EMI).

Regarding the indexes I11 to I1n, the indexes I21 to I2n, and the indexes I31 to I3n, at least one of the indexes may include the square of a ratio of the frequency of a corresponding memory to the frequency of an interface.

Regarding the indexes I11 to I1n, the indexes I21 to I2n, and the indexes I31 to I3n, at least one of the indexes may include a ratio of a first value to a second value, the first value is a smaller one of the number of read operations and the number of write operations, and the second value is a larger one of the number of read operations and the number of write operations. In other words, when the number of write operations is close to the number of read operations, the access latency may be longer since the operation mode of the memory should be switched frequently. When one of the number of read operations and the number of write operations is much greater than the other, the access latency may be shorter since the operation mode of the memory is less switched.

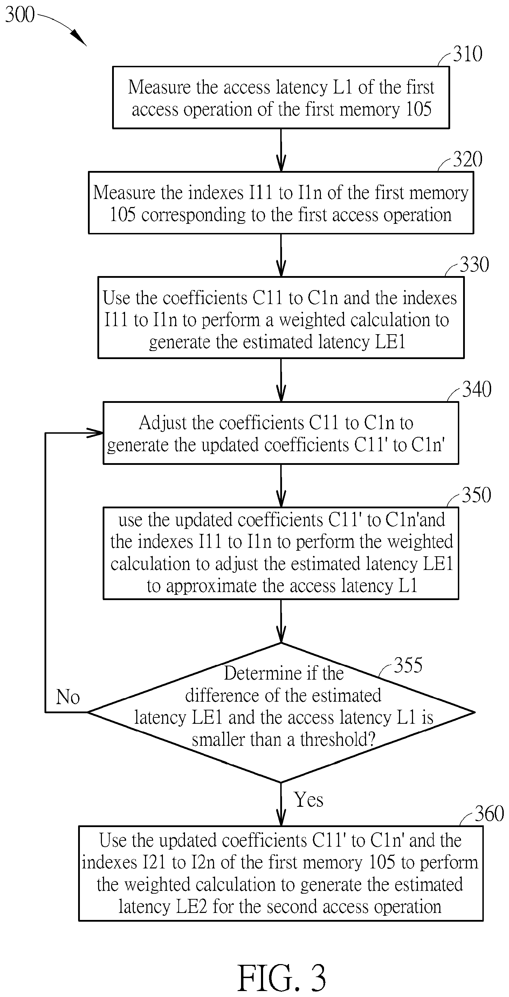

FIG.3 illustrates a flowchart of a memory access latency estimation method 300 for the memory access latency estimation system 100 in FIG. 1 according to an embodiment. The memory access latency estimation method 300 may include the following steps.
Step 310: measure the access latency L1 of the first access operation of the first memory 105;
Step 320: measure the indexes I11 to I1n of the first memory 105 corresponding to the first access operation;
Step 330: use the coefficients C11 to C1n and the indexes I11 to I1n to perform a weighted calculation to generate the estimated latency LE1;
Step 340: adjust the coefficients C11 to C1n to generate the updated coefficients C11' to C1n';
Step 350: use the updated coefficients C11' to C1n'and the indexes I11 to I1n to perform the weighted calculation to adjust the estimated latency LE1 to approximate the access latency L1;
Step 355: determine if the difference of the estimated latency LE1 and the access latency L1 is smaller than a threshold? If so, enter Step 360; otherwise, enter Step 340; and
Step 360: use the updated coefficients C11' to C1n' and the indexes I21 to I2n of the first memory 105 to perform the weighted calculation to generate the estimated latency LE2 for the second access operation.

In Step 310 to Step 355, the processor 130 may perform optimization to generate the updated coefficients C11' to C1n' to make the estimated access latency closer to the actual access latency. Optionally, Step 355 may be omitted. In Step 360, the updated coefficients C11' to C1n' may be used to generate the estimated latency LE2 for the second access operation of the first memory 105 before the actual access latency is measured, and the estimated latency LE2 may be used to control the memory 105 and manage the power consumption.

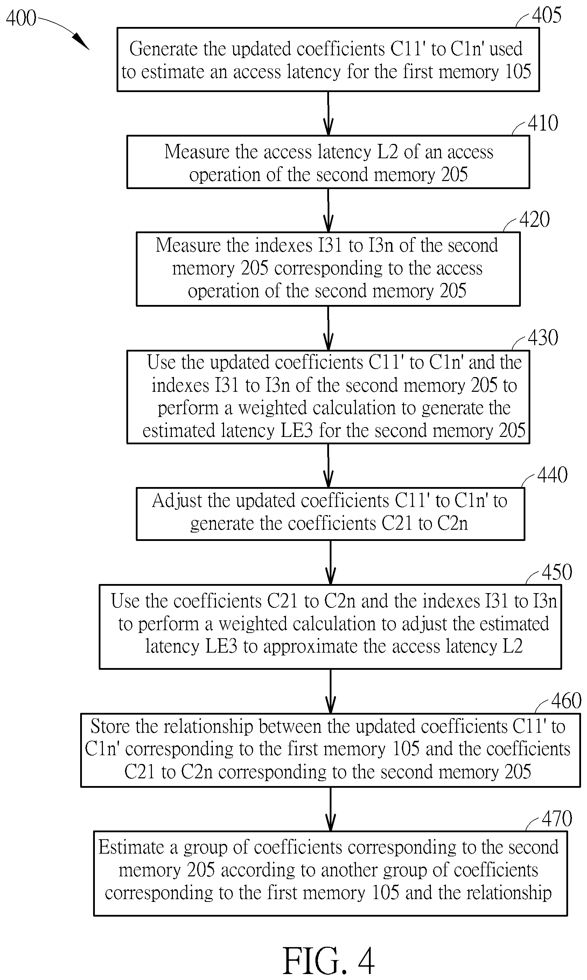

FIG.4 illustrates a flowchart of a memory access latency estimation method 400 for the memory access latency estimation system 200 in FIG.2 according to another embodiment. The method 400 may include the following steps.
Step 405: generate the updated coefficients C11' to C1n' used to estimate an access latency for the first memory 105;
Step 410: measure the access latency L2 of an access operation of the second memory 205;
Step 420: measure the indexes I31 to I3n of the second memory 205 corresponding to the access operation of the second memory 205;
Step 430: use the updated coefficients C11' to C1n' and the indexes I31 to I3n of the second memory 205 to perform a weighted calculation to generate the estimated latency LE3 for the second memory 205;
Step 440: adjust the updated coefficients C11' to C1n' to generate the coefficients C21 to C2n;
Step 450: use the coefficients C21 to C2n and the indexes I31 to I3n to perform a weighted calculation to adjust the estimated latency LE3 to approximate the access latency L2;
Step 460: store the relationship (e.g. the abovementioned f()) between the updated coefficients C11' to C1n' corresponding to the first memory 105 and the coefficients C21 to C2n corresponding to the second memory 205; and
Step 470: estimate a group of coefficients corresponding to the second memory 205 according to another group of coefficients corresponding to the first memory 105 and the relationship.

Step 405 may include Step 310 to Step 355 of FIG.1 to generate and optimize the updated coefficients C11' to C1n' used to estimate the access latency of the first memory 105. Optionally, Step 440 and Step 450 may be performed repeatedly to adjust the coefficients C21 to C2n until a difference of the generated estimated access latency (e.g. LE3) and the actual access latency L2 is smaller than a threshold. In Step 460, the neural network model in the processor 130 may be used to analyze and generate the relationship (e.g. the abovementioned function f()). In Step 460, the function (e.g. the function f()) of the relationship may be generated according to a posterior probability and/or linear regression using a machine learning model and/or a neural network model of the processor 130. In Step 470, the relationship (e.g. the function f()) may be applied to find the group of coefficients corresponding to the second memory 205 for estimating the access latency for the second memory 205.

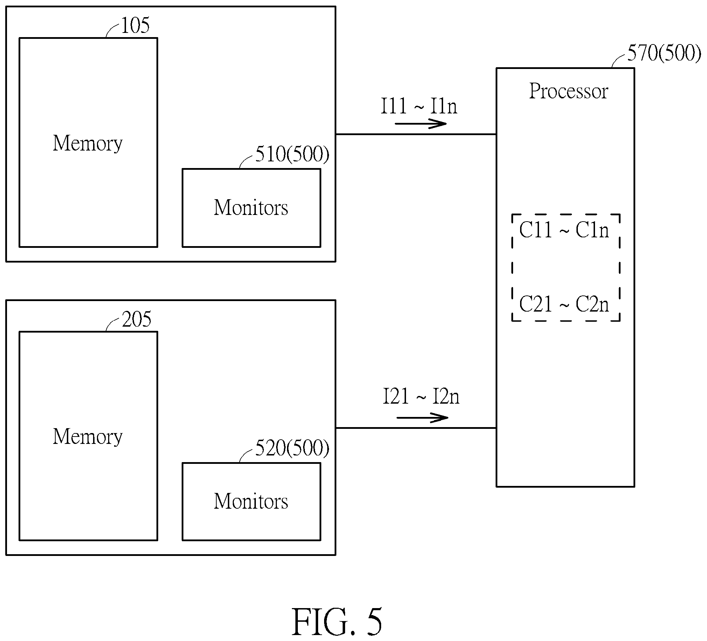

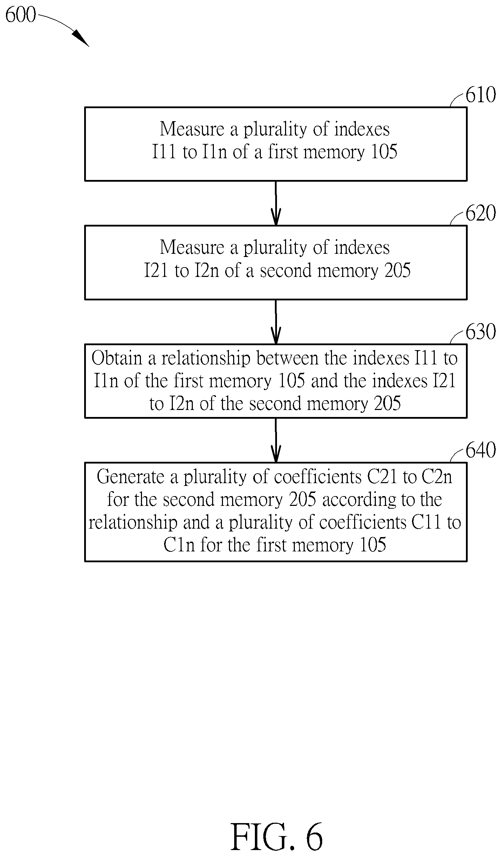

FIG.5 illustrates a memory access latency estimation system 500 for controlling the first memory 105 and a second memory 205 according to another embodiment. The memory access latency estimation system 500 can include monitors 510, monitors 520 and a processor 570. FIG.6 is a flowchart of a memory access latency estimation method 600 for the memory access latency estimation system 500 in FIG.5. The memory access latency estimation method 600 may include the following steps.
Step 610: measure a plurality of indexes I11 to I1n of a first memory 105;
Step 620: measure a plurality of indexes I21 to I2n of a second memory 205;
Step 630: obtain a relationship between the indexes I11 to I1n of the first memory 105 and the indexes I21 to I2n of the second memory 205; and
Step 640:generate a plurality of coefficients C21 to C2n for the second memory 205 according to the relationship and a plurality of coefficients C11 to C1n for the first memory 105.

In FIG.5 and FIG.6, the memory 105 can be embedded in a first chip, and the second memory 205 can be embedded in a second chip. For example, if the first chip is modified and upgraded to design the second chip, the coefficients for estimating the latency of the first memory 105 in the first chip may be converted to the coefficients for estimating the latency of the second memory 205 in the second chip.

Prior to Step 610, a known formula can be used to calculate the access latency of the first memory 105. In this formula, number and types of the indexes I11 to I1n can be fixed. In this formula, the coefficients C11 to C1n, which are used to calculate the access latency of the first memory 105, have been optimized and are now fixed. This formula can be applied for a weighted calculation, for instance, the calculation like C11*I11+C12*I12+...+C1n*I1n to generate the access latency of the first memory 105.

In Step 610, the monitors 510 can measure the first memory 105 to generate the indexes I11 to I1n. The characteristics of the first memory 105 can be measured according to the indexes I11 to I1n.

In Step 620, the monitors 520 can measure the second memory 205 to generate the indexes I21 to I2n. The characteristics of the second memory 205 can be measured according to the indexes I21 to I2n.

In Step 630, the relationship can correspond to a mapping between the characteristics of the first memory 105 and the second memory 205.

In Step 630, a neural network model in the processor 570 may be used to analyze and generate the relationship between the indexes I11 to I1n (of the first memory 105) and the indexes I21 to I2n (of the second memory 205). In Step 630, the relationship may be a function generated according to a posterior probability and/or linear regression using a machine learning model and/or a neural network model of the processor 570. The relationship in Step 630 can be expressed as a function and a formula.

The number and the types of the indexes I11 to I1n can be the same as the number and types of the indexes I21 to I2n.

In Step 640, the coefficients C21 to C2n for the second memory 205 can be generated according to the known coefficients C11 to C1n of the first memory 105 and the relationship obtained in Step 630.

After obtaining the coefficients C21 to C2n, the coefficients C21 to C2n can be used to estimate the access latency of the second memory 205. The coefficients C21 to C2n and a group of measured indexes I21' to I2n' of the second memory 205 can be used to perform a weighted calculation to estimate the access latency of the second memory 205. For example, the estimated access latency of the second memory 205 can be generated with a formula such as C21 *I21' + C22*I22' + ... + C2n*I2n'.

In summary, with the memory access latency estimation system 100 and the memory access latency estimation method 300, an access latency of an access operation of a memory may be estimated. With the memory access latency estimation system 200 and the memory access latency estimation method 400, the coefficients for estimating the access latency for the second memory 205 may be generated according known coefficients for the first memory 105. With the memory access latency estimation system 500 and the memory access latency estimation method 600, the coefficients for estimating the access latency of the second memory 205 can be generated according known coefficients for the first memory 105. Hence, the effort for calculating the coefficients for the second memory 205 is effectively reduced. Hence, an improved solution for estimating memory access latency is provided based on machine learning and neural network model, and it is helpful for power management to reduce the power consumption.

Those skilled in the art will readily observe that numerous modifications and alterations of the device and method may be made within the scope of the appended claims. Accordingly, the above disclosure should be construed as limited only by the metes and bounds of the appended claims.

## Claims

1. A memory access latency estimation method, comprising:
measuring a first access latency of a first access operation of a first memory (310);
measuring a plurality of first indexes of the first memory corresponding to the first access operation (320);
using a plurality of first coefficients and the plurality of first indexes to perform a first weighted calculation by multiplying each first index by one corresponding first coefficient to generate a plurality of weighted first indexes, and by adding the weighted first indexes to generate a first estimated latency for the first access operation (330);
adjusting the plurality of first coefficients to generate a plurality of updated first coefficients (340);
using the plurality of updated first coefficients and the plurality of first indexes to perform the first weighted calculation to adjust the first estimated latency for the first estimated latency to approximate the first access latency (350);
using the plurality of updated first coefficients and a plurality of second indexes of the first memory to perform a second weighted calculation by multiplying each second index by one corresponding updated first coefficient to generate a plurality of weighted second indexes, and by adding the weighted second indexes to generate a second estimated latency for a second access operation (360) of the first memory; and
using the second estimated latency to manage and reduce a power consumption of the second operation of the first memory;
wherein number and types of the plurality of first indexes are the same as number and types of the plurality of second indexes, the plurality of second indexes are corresponding to the second access operation, and the first access operation precedes the second access operation.

2. The method of claim 1, further comprising:
determining if a difference of the first estimated latency and the first access latency is smaller than a threshold (355); and
if the difference is not smaller than the threshold, adjusting the plurality of updated first coefficients to adjust the first estimated latency to be closer to the first access latency and reduce the difference (340).

3. The method of claim 1 or 2, wherein at least one of the plurality of first indexes comprises a bandwidth of the first memory.

4. The method of any one of claims 1 to 3, wherein at least one of the plurality of first indexes comprises a reciprocal of an operation frequency of the first memory; and/or wherein at least one of the plurality of first indexes comprises a reciprocal of an operation frequency of an interface for the first memory.

5. The method of any one of claims 1 to 4, wherein at least one of the plurality of first indexes comprises a reciprocal of a parameter corresponding to a transaction priority.

6. The method of any one of claims 1 to 5, wherein at least one of the plurality of first indexes comprises a parameter corresponding to variety of access patterns.

7. The method of any one of claims 1 to 6, wherein at least one of the plurality of first indexes comprises a squared value of the bandwidth of the first memory.

8. The method of any one of claims 1 to 7, wherein at least one of the plurality of first indexes comprises a ratio of a frequency of the first memory to a frequency of an interface.

9. The method of any one of claims 1 to 8, wherein at least one of the plurality of first indexes comprises square of a ratio of a frequency of the first memory to a frequency of an interface.

10. The method of any one of claims 1 to 9, wherein at least one of the plurality of first indexes comprises a ratio of a first value to a second value, the first value is a smaller one of a number of read operations and a number of write operations, and the second value is a larger one of the number of read operations and the number of write operations.

11. The method of any one of claims 1 to 10, further comprising:
measuring a second access latency of a third access operation of a second memory (410);
measuring a plurality of third indexes of the second memory corresponding to the third access operation (420);
using the plurality of updated first coefficients and the plurality of third indexes to perform a third weighted calculation by multiplying each third index by one corresponding updated first coefficient to generate a plurality of weighted third indexes, and by adding the weighted third indexes to generate a third estimated latency for the third access operation (430);
adjusting the plurality of updated first coefficients to generate a plurality of second coefficients (440);
using the plurality of second coefficients and the plurality of third indexes to perform the third weighted calculation to adjust the third estimated latency for the third estimated latency to approximate the second access latency (450);
storing a relationship between the plurality of updated first coefficients corresponding to the first memory and the plurality of second coefficients corresponding to the second memory (460); and
estimating a group of coefficients corresponding to the second memory according to another group of coefficients corresponding to the first memory and the relationship (470);
wherein the number and the types of the plurality of first indexes are the same as number and types of the plurality of third indexes.

12. A memory access latency estimation system (100; 200), comprising:
a first monitor (110) configured to measure a first access latency (L1) of a first access operation of a first memory (105);
a plurality of second monitors (120) configured to measuring a plurality of first indexes (L11 - L1n) of the first memory (105) corresponding to the first access operation; and
a processor (130) configured to use a plurality of first coefficients (C11 - C1n) and the plurality of first indexes (L11 - L1n) to perform a first weighted calculation by multiplying each first index by one corresponding first coefficient to generate a plurality of weighted first indexes, and by adding the weighted first indexes to generate a first estimated latency (LE1) for the first access operation, adjust the plurality of first coefficients (C11 - C1n) to generate a plurality of updated first coefficients (C11' - C1n') in order to use the plurality of updated first coefficients (C11' - C1n') and the plurality of first indexes (L11 - L1n) to perform the first weighted calculation to adjust the first estimated latency (LE1) for the first estimated latency (LE1) to approximate the first access latency (L1), use the plurality of updated first coefficients (C11' - C1n') and a plurality of second indexes (L21 - L2n) of the first memory (105) to perform a second weighted calculation by multiplying each second index by one corresponding updated first coefficient to generate a plurality of weighted second indexes, and by adding the weighted second indexes to generate a second estimated latency (LE2) for a second access operation of the first memory (105), and use the second estimated latency to manage and reduce a power consumption of the second operation of the first memory;
wherein number and types of the plurality of first indexes (L11 - L1n) are the same as number and types of the plurality of second indexes (L21 - L2n), the plurality of second indexes (L21 - L2n) are corresponding to the second access operation, and the first access operation precedes the second access operation.

13. The memory access latency estimation system (200) of claim 12, further comprising:
a third monitor (210) configured to measure a second access latency (L2) of a third access operation of a second memory (205); and
a plurality of fourth monitors (220) configured to measure a plurality of third indexes (I31 - I3n) of the second memory (205) corresponding to the third access operation;
wherein the processor (130) is further configured to use the plurality of updated first coefficients (C11' - C1n') and the plurality of third indexes (I31 - I3n) to perform a third weighted calculation by multiplying each third index by one corresponding updated first coefficient to generate a plurality of weighted third indexes, and by adding the weighted third indexes to generate a third estimated latency (LE3) for the third access operation, adjust the plurality of updated first coefficients (C11' - C1n') to generate a plurality of second coefficients (C21 - C2n), use the plurality of second coefficients (C21 - C2n) and the plurality of third indexes (I31 - I3n) to perform the third weighted calculation to adjust the third estimated latency (LE3) for the third estimated latency (LE3) to approximate the second access latency (L2), store a relationship between the plurality of updated first coefficients (C11' - C1n') corresponding to the first memory (105) and the plurality of second coefficients (C21 - C2n) corresponding to the second memory (205), and estimate a group of coefficients corresponding to the second memory (205) according to another group of coefficients corresponding to the first memory (105) and the relationship; and
the number and the types of the plurality of first indexes (L11 - L1n) are the same as a number and types of the plurality of third indexes (I31 - I3n).

## Patentansprüche

1. Verfahren zur Schätzung der Speicherzugriffslatenz, umfassend:
Messen einer ersten Zugriffslatenz einer ersten Zugriffsoperation eines ersten Speichers (310);
Messen einer Vielzahl von ersten Indizes des ersten Speichers, die zu der ersten Zugriffsoperation korrespondieren (320);
Verwenden einer Vielzahl von ersten Koeffizienten und der Vielzahl von ersten Indizes, um eine erste gewichtete Berechnung durchzuführen, indem jeder erste Index mit einem korrespondierenden ersten Koeffizienten multipliziert wird, um eine Vielzahl von gewichteten ersten Indizes zu erzeugen, und indem die gewichteten ersten Indizes addiert werden, um eine erste geschätzte Latenz für die erste Zugriffsoperation zu erzeugen (330);
Anpassen der Vielzahl von ersten Koeffizienten, um eine Vielzahl von aktualisierten ersten Koeffizienten zu erzeugen (340);
Verwenden der Vielzahl von aktualisierten ersten Koeffizienten und der Vielzahl von ersten Indizes, um die erste gewichtete Berechnung durchzuführen, um die erste geschätzte Latenz so anzupassen, dass sich die erste geschätzte Latenz an die erste Zugriffslatenz annähert (350);
Verwenden der Vielzahl von aktualisierten ersten Koeffizienten und einer Vielzahl von zweiten Indizes des ersten Speichers, um eine zweite gewichtete Berechnung durchzuführen, indem jeder zweite Index mit einem korrespondierenden aktualisierten ersten Koeffizienten multipliziert wird, um eine Vielzahl von gewichteten zweiten Indizes zu erzeugen, und indem die gewichteten zweiten Indizes addiert werden, um eine zweite geschätzte Latenz für eine zweite Zugriffsoperation des ersten Speichers zu erzeugen (360); und
Verwenden der zweiten geschätzten Latenz, um einen Stromverbrauch der zweiten Operation des ersten Speichers zu verwalten und zu reduzieren;
wobei Anzahl und Typen der Vielzahl von ersten Indizes die gleichen sind wie Anzahl und Typen der Vielzahl von zweiten Indizes, die Vielzahl von zweiten Indizes zu der zweiten Zugriffsoperation korrespondieren und die erste Zugriffsoperation der zweiten Zugriffsoperation vorausgeht.

2. Verfahren nach Anspruch 1, ferner umfassend:
Bestimmen, ob eine Differenz der ersten geschätzten Latenz und der ersten Zugriffslatenz kleiner als ein Schwellenwert ist (355); und
wenn die Differenz nicht kleiner als der Schwellenwert ist, Anpassen der Vielzahl von aktualisierten ersten Koeffizienten, um die erste geschätzte Latenz so anzupassen, dass sie näher an der ersten Zugriffslatenz ist, und die Differenz zu reduzieren (340).

3. Verfahren nach Anspruch 1 oder 2, wobei mindestens einer der Vielzahl von ersten Indizes eine Bandbreite des ersten Speichers umfasst.

4. Verfahren nach einem der Ansprüche 1 bis 3, wobei mindestens einer der Vielzahl von ersten Indizes einen Kehrwert einer Betriebsfrequenz des ersten Speichers umfasst; und/oder
wobei mindestens einer der Vielzahl von ersten Indizes einen Kehrwert einer Betriebsfrequenz einer Schnittstelle für den ersten Speicher umfasst.

5. Verfahren nach einem der Ansprüche 1 bis 4, wobei mindestens einer der Vielzahl von ersten Indizes einen Kehrwert eines Parameters umfasst, der zu einer Transaktionspriorität korrespondiert.

6. Verfahren nach einem der Ansprüche 1 bis 5, wobei mindestens einer der Vielzahl von ersten Indizes einen Parameter umfasst, der zu einer Vielfalt von Zugriffsmustern korrespondiert.

7. Verfahren nach einem der Ansprüche 1 bis 6, wobei mindestens einer der Vielzahl von ersten Indizes einen quadrierten Wert der Bandbreite des ersten Speichers umfasst.

8. Verfahren nach einem der Ansprüche 1 bis 7, wobei mindestens einer der Vielzahl von ersten Indizes ein Verhältnis einer Frequenz des ersten Speichers zu einer Frequenz einer Schnittstelle umfasst.

9. Verfahren nach einem der Ansprüche 1 bis 8, wobei mindestens einer der Vielzahl von ersten Indizes ein Quadrat eines Verhältnisses einer Frequenz des ersten Speichers zu einer Frequenz einer Schnittstelle umfasst.

10. Verfahren nach einem der Ansprüche 1 bis 9, wobei mindestens einer der Vielzahl von ersten Indizes ein Verhältnis eines ersten Werts zu einem zweiten Wert umfasst, wobei der erste Wert ein kleinerer von einer Anzahl von Lesevorgängen und einer Anzahl von Schreibvorgängen ist, und der zweite Wert ein größerer von der Anzahl von Lesevorgängen und der Anzahl von Schreibvorgängen ist.

11. Verfahren nach einem der Ansprüche 1 bis 10, ferner umfassend:
Messen einer zweiten Zugriffslatenz einer dritten Zugriffsoperation eines zweiten Speichers (410);
Messen einer Vielzahl von dritten Indizes des zweiten Speichers, die zu der dritten Zugriffsoperation korrespondieren (420);
Verwenden der Vielzahl von aktualisierten ersten Koeffizienten und der Vielzahl von dritten Indizes, um eine dritte gewichtete Berechnung durchzuführen, indem jeder dritte Index mit einem korrespondierenden aktualisierten ersten Koeffizienten multipliziert wird, um eine Vielzahl von gewichteten dritten Indizes zu erzeugen, und indem die gewichteten dritten Indizes addiert werden, um eine dritte geschätzte Latenz für die dritte Zugriffsoperation zu erzeugen (430);
Anpassen der Vielzahl von aktualisierten ersten Koeffizienten, um eine Vielzahl von zweiten Koeffizienten zu erzeugen (440);
Verwenden der Vielzahl von zweiten Koeffizienten und der Vielzahl von dritten Indizes, um die dritte gewichtete Berechnung durchzuführen, um die dritte geschätzte Latenz so anzupassen, dass sich die dritte geschätzte Latenz an die zweite Zugriffslatenz annähert (450);
Speichern einer Beziehung zwischen der Vielzahl von aktualisierten ersten Koeffizienten, die zu dem ersten Speicher korrespondieren, und der Vielzahl von zweiten Koeffizienten, die zu dem zweiten Speicher korrespondieren (460); und
Schätzen einer Gruppe von Koeffizienten, die zu dem zweiten Speicher korrespondieren, gemäß einer anderen Gruppe von Koeffizienten, die zu dem ersten Speicher korrespondieren, und der Beziehung (470);
wobei die Anzahl und die Typen der Vielzahl von ersten Indizes die gleichen sind wie Anzahl und Typen der Vielzahl von dritten Indizes.

12. System (100; 200) zur Schätzung der Speicherzugriffslatenz, umfassend:
eine erste Überwachungseinrichtung (110), die konfiguriert ist, um eine erste Zugriffslatenz (L1) einer ersten Zugriffsoperation eines ersten Speichers (105) zu messen;
eine Vielzahl von zweiten Überwachungseinrichtungen (120), die konfiguriert sind, um eine Vielzahl von ersten Indizes (L11 - L1n) des ersten Speichers (105), die zu der ersten Zugriffsoperation korrespondieren, zu messen; und
einen Prozessor (130), der konfiguriert ist, um eine Vielzahl von ersten Koeffizienten (C11 - C1n) und die Vielzahl von ersten Indizes (L11 - L1n) zu verwenden, um eine erste gewichtete Berechnung durchzuführen, indem jeder erste Index mit einem korrespondierenden ersten Koeffizienten multipliziert wird, um eine Vielzahl von gewichteten ersten Indizes zu erzeugen, und indem die gewichteten ersten Indizes addiert werden, um eine erste geschätzte Latenz (LE1) für die erste Zugriffsoperation zu erzeugen, die Vielzahl von ersten Koeffizienten (C11 - C1n) anzupassen, um eine Vielzahl von aktualisierten ersten Koeffizienten (C11' - C1n') zu erzeugen, um die Vielzahl von aktualisierten ersten Koeffizienten (C11' - C1n') und die Vielzahl von ersten Indizes (L11 - L1n) zu verwenden, um die erste gewichtete Berechnung durchzuführen, um die erste geschätzte Latenz (LE1) so anzupassen, dass sich die erste geschätzte Latenz (LE1) an die erste Zugriffslatenz (L1) annähert, die Vielzahl von aktualisierten ersten Koeffizienten (C11' - C1n') und eine Vielzahl von zweiten Indizes (L21 - L2n) des ersten Speichers (105) zu verwenden, um eine zweite gewichtete Berechnung durchzuführen, indem jeder zweite Index mit einem korrespondierenden aktualisierten ersten Koeffizienten multipliziert wird, um eine Vielzahl von gewichteten zweiten Indizes zu erzeugen, und indem die gewichteten zweiten Indizes addiert werden, um eine zweite geschätzte Latenz (LE2) für eine zweite Zugriffsoperation des ersten Speichers (105) zu erzeugen, und die zweite geschätzte Latenz zu verwenden, um einen Stromverbrauch der zweiten Operation des ersten Speichers zu verwalten und zu reduzieren;
wobei Anzahl und Typen der Vielzahl von ersten Indizes (L11 - L1n) die gleichen sind wie Anzahl und Typen der Vielzahl von zweiten Indizes (L21 - L2n), die Vielzahl von zweiten Indizes (L21 - L2n) zu der zweiten Zugriffsoperation korrespondieren und die erste Zugriffsoperation der zweiten Zugriffsoperation vorausgeht.

13. System (200) zur Schätzung der Speicherzugriffslatenz nach Anspruch 12, ferner umfassend:
eine dritte Überwachungseinrichtung (210), die konfiguriert ist, um eine zweite Zugriffslatenz (L2) einer dritten Zugriffsoperation eines zweiten Speichers (205) zu messen; und
eine Vielzahl von vierten Überwachungseinrichtungen (220), die konfiguriert sind, um eine Vielzahl von dritten Indizes (I31 - I3n) des zweiten Speichers (205), die zu der dritten Zugriffsoperation korrespondieren, zu messen;
wobei der Prozessor (130) ferner konfiguriert ist, um die Vielzahl von aktualisierten ersten Koeffizienten (C11' - C1n') und die Vielzahl von dritten Indizes (I31 - I3n) zu verwenden, um eine dritte gewichtete Berechnung durchzuführen, indem jeder dritte Index mit einem korrespondierenden aktualisierten ersten Koeffizienten multipliziert wird, um eine Vielzahl von gewichteten dritten Indizes zu erzeugen, und indem die gewichteten dritten Indizes addiert werden, um eine dritte geschätzte Latenz (LE3) für die dritte Zugriffsoperation zu erzeugen, die Vielzahl von aktualisierten ersten Koeffizienten (C11' - C1n') anzupassen, um eine Vielzahl von zweiten Koeffizienten (C21 - C2n) zu erzeugen, die Vielzahl von zweiten Koeffizienten (C21 - C2n) und die Vielzahl von dritten Indizes (I31 - I3n) zu verwenden, um die dritte gewichtete Berechnung durchzuführen, um die dritte geschätzte Latenz (LE3) so anzupassen, dass sich die dritte geschätzte Latenz (LE3) an die zweite Zugriffslatenz (L2) annähert, eine Beziehung zwischen der Vielzahl von aktualisierten ersten Koeffizienten (C11' - C1n'), die zu dem ersten Speicher (105) korrespondieren, und der Vielzahl von zweiten Koeffizienten (C21 - C2n), die zu dem zweiten Speicher (205) korrespondieren, zu speichern und eine Gruppe von Koeffizienten, die zu dem zweiten Speicher (205) korrespondieren, gemäß einer anderen Gruppe von Koeffizienten, die zu dem ersten Speicher (105) korrespondieren, und der Beziehung zu schätzen; und
die Anzahl und die Typen der Vielzahl von ersten Indizes (L11 - L1n) die gleichen sind wie eine Anzahl und Typen der Vielzahl von dritten Indizes (I31 - I3n).

## Revendications

1. Procédé d'estimation de latence d'accès à la mémoire, comprenant :
la mesure d'une première latence d'accès d'une première opération d'accès d'une première mémoire (310) ;
la mesure d'une pluralité de premiers indices de la première mémoire correspondant à la première opération d'accès (320) ;
l'utilisation d'une pluralité de premiers coefficients et de la pluralité de premiers indices pour effectuer un premier calcul pondéré en multipliant chaque premier indice par un premier coefficient correspondant pour générer une pluralité de premiers indices pondérés, et en ajoutant les premiers indices pondérés pour générer une première latence estimée pour la première opération d'accès (330) ;
l'ajustement de la pluralité de premiers coefficients pour générer une pluralité de premiers coefficients mis à jour (340) ;
l'utilisation de la pluralité de premiers coefficients mis à jour et de la pluralité de premiers indices pour effectuer le premier calcul pondéré pour ajuster la première latence estimée pour la première latence estimée pour approcher la première latence d'accès (350) ;
l'utilisation de la pluralité de premiers coefficients mis à jour et d'une pluralité de seconds indices de la première mémoire pour effectuer un second calcul pondéré en multipliant chaque second indice par un premier coefficient mis à jour correspondant pour générer une pluralité de seconds indices pondérés, et en ajoutant les seconds indices pondérés pour générer une seconde latence estimée pour une seconde opération d'accès (360) de la première mémoire ; et
l'utilisation de la seconde latence estimée pour gérer et réduire une consommation d'énergie de la seconde opération de la première mémoire ;
dans lequel le nombre et les types de la pluralité de premiers indices sont les mêmes que le nombre et les types de la pluralité de seconds indices, la pluralité de seconds indices correspondent à la seconde opération d'accès, et la première opération d'accès précède la seconde opération d'accès.

2. Procédé selon la revendication 1, comprenant en outre :
la détermination si une différence de la première latence estimée et de la première latence d'accès est inférieure à un seuil (355) ; et
si la différence n'est pas inférieure au seuil, l'ajustement de la pluralité de premiers coefficients mis à jour pour ajuster la première latence estimée pour qu'elle soit plus proche de la première latence d'accès et réduire la différence (340).

3. Procédé selon la revendication 1 ou 2, dans lequel au moins l'un de la pluralité de premiers index comprend une largeur de bande de la première mémoire.

4. Procédé selon l'une quelconque des revendications 1 à 3, dans lequel au moins l'un de la pluralité de premiers index comprend une réciproque d'une fréquence de fonctionnement de la première mémoire ; et/ou
dans lequel au moins l'un de la pluralité de premiers index comprend une réciproque d'une fréquence de fonctionnement d'une interface pour la première mémoire.

5. Procédé selon l'une quelconque des revendications 1 à 4, dans lequel au moins l'un de la pluralité de premiers index comprend une réciproque d'un paramètre correspondant à une priorité de transaction.

6. Procédé selon l'une quelconque des revendications 1 à 5, dans lequel au moins l'un de la pluralité de premiers index comprend un paramètre correspondant à une variété de modèles d'accès.

7. Procédé selon l'une quelconque des revendications 1 à 6, dans lequel au moins l'un de la pluralité de premiers index comprend une valeur au carré de la largeur de bande de la première mémoire.

8. Procédé selon l'une quelconque des revendications 1 à 7, dans lequel au moins l'un de la pluralité de premiers index comprend un rapport d'une fréquence de la première mémoire sur une fréquence d'une interface.

9. Procédé selon l'une quelconque des revendications 1 à 8, dans lequel au moins l'un de la pluralité de premiers index comprend un carré d'un rapport d'une fréquence de la première mémoire sur une fréquence d'une interface.

10. Procédé selon l'une quelconque des revendications 1 à 9, dans lequel au moins l'un de la pluralité de premiers index comprend un rapport d'une première valeur sur une seconde valeur, la première valeur est une plus petite d'un nombre d'opérations de lecture et d'un nombre d'opérations d'écriture, et la seconde valeur est une plus grande du nombre d'opérations de lecture et du nombre d'opérations d'écriture.

11. Procédé selon l'une quelconque des revendications 1 à 10, comprenant en outre :
la mesure d'une deuxième latence d'accès d'une troisième opération d'accès d'une deuxième mémoire (410) ;
la mesure d'une pluralité de troisièmes indices de la deuxième mémoire correspondant à la troisième opération d'accès (420) ;
l'utilisation de la pluralité de premiers coefficients mis à jour et de la pluralité de troisièmes indices pour effectuer un troisième calcul pondéré en multipliant chaque troisième indice par un premier coefficient mis à jour correspondant pour générer une pluralité de troisièmes indices pondérés, et en ajoutant les troisièmes indices pondérés pour générer une troisième latence estimée pour la troisième opération d'accès (430) ;
l'ajustement de la pluralité de premiers coefficients mis à jour pour générer une pluralité de deuxièmes coefficients (440) ;
l'utilisation de la pluralité de deuxièmes coefficients et de la pluralité de troisièmes indices pour effectuer le troisième calcul pondéré pour ajuster la troisième latence estimée pour la troisième latence estimée pour approcher la deuxième latence d'accès (450) ;
le stockage d'une relation entre la pluralité de premiers coefficients mis à jour correspondant à la première mémoire et la pluralité de deuxièmes coefficients correspondant à la deuxième mémoire (460) ; et
l'estimation d'un groupe de coefficients correspondant à la deuxième mémoire en fonction d'un autre groupe de coefficients correspondant à la première mémoire et de la relation (470) ;
dans lequel le nombre et les types de la pluralité de premiers indices sont les mêmes que le nombre et les types de la pluralité de troisièmes indices.

12. Système d'estimation de latence d'accès à la mémoire (100 ; 200), comprenant :
un premier dispositif de surveillance (110) configuré pour mesurer une première latence d'accès (L1) d'une première opération d'accès d'une première mémoire (105) ;
une pluralité de deuxièmes dispositifs de surveillance (120) configurés pour mesurer une pluralité de premiers indices (L11 - L1n) de la première mémoire (105) correspondant à la première opération d'accès ; et
un processeur (130) configuré pour utiliser une pluralité de premiers coefficients (C11 - C1n) et la pluralité de premiers indices (L11 - L1n) pour effectuer un premier calcul pondéré en multipliant chaque premier indice par un premier coefficient correspondant pour générer une pluralité de premiers indices pondérés, et en ajoutant les premiers indices pondérés pour générer une première latence estimée (LE1) pour la première opération d'accès, ajuster la pluralité de premiers coefficients (C11 - C1n) pour générer une pluralité de premiers coefficients mis à jour (C11' - C1n') afin d'utiliser la pluralité de premiers coefficients mis à jour (C11' - C1n') et la pluralité de premiers indices (L11 - L1n) pour effectuer le premier calcul pondéré pour ajuster la première latence estimée (LE1) pour la première latence estimée (LE1) pour approcher la première latence d'accès (L1), utiliser la pluralité de premiers coefficients mis à jour (C11' - C1n') et une pluralité de seconds indices (L21 - L2n) de la première mémoire (105) pour effectuer un second calcul pondéré en multipliant chaque second indice par un premier coefficient mis à jour correspondant pour générer une pluralité de seconds indices pondérés, et en ajoutant les seconds indices pondérés pour générer une seconde latence estimée (LE2) pour une seconde opération d'accès de la première mémoire (105), et utiliser la seconde latence estimée pour gérer et réduire une consommation d'énergie de la seconde opération de la première mémoire ;
dans lequel le nombre et les types de la pluralité de premiers indices (L11 - L1n) sont les mêmes que le nombre et les types de la pluralité de seconds indices (L21 - L2n), la pluralité de seconds indices (L21 - L2n) correspondent à la seconde opération d'accès, et la première opération d'accès précède la seconde opération d'accès.

13. Système d'estimation de latence d'accès à la mémoire (200) selon la revendication 12, comprenant en outre :
un troisième dispositif de surveillance (210) configuré pour mesurer une seconde latence d'accès (L2) d'une troisième opération d'accès d'une seconde mémoire (205) ; et
une pluralité de quatrièmes dispositifs de surveillance (220) configurés pour mesurer une pluralité de troisièmes indices (I31 - I3n) de la seconde mémoire (205) correspondant à la troisième opération d'accès ;
dans lequel le processeur (130) est en outre configuré pour utiliser la pluralité de premiers coefficients mis à jour (C11' - C1n') et la pluralité de troisièmes indices (I31 - I3n) pour effectuer un troisième calcul pondéré en multipliant chaque troisième indice par un premier coefficient mis à jour correspondant pour générer une pluralité de troisièmes indices pondérés, et en ajoutant les troisièmes indices pondérés pour générer une troisième latence estimée (LE3) pour la troisième opération d'accès, ajuster la pluralité de premiers coefficients mis à jour (C11' - C1n') pour générer une pluralité de deuxièmes coefficients (C21 - C2n), utiliser la pluralité de deuxièmes coefficients (C21 - C2n) et la pluralité de troisièmes indices (I31 - I3n) pour effectuer le troisième calcul pondéré pour ajuster la troisième latence estimée (LE3) pour la troisième latence estimée (LE3) pour approcher la seconde latence d'accès (L2), stocker une relation entre la pluralité de premiers coefficients mis à jour (C11' - C1n') correspondant à la première mémoire (105) et la pluralité de deuxièmes coefficients (C21 - C2n) correspondant à la seconde mémoire (205), et estimer un groupe de coefficients correspondant à la seconde mémoire (205) en fonction d'un autre groupe de coefficients correspondant à la première mémoire (105) et de la relation ; et
le nombre et les types de la pluralité de premiers indices (L11 - L1n) sont les mêmes qu'un nombre et des types de la pluralité de troisièmes indices (I31 - I3n).
